# EUROPÄISCHE PATENTANMELDUNG

(11) **EP 0 596 352 A1**
(43) Veröffentlichungstag der Anmeldung: **11.05.1994**
(21) Anmeldenummer: 93117213.4
(22) Anmeldetag: 22.10.1993
(51) Int. Cl.: H03K 3/30

(54) **Freischwingende Stromversorgungsschaltung**

(30) Priorität: 04.11.1992 DE 4237261; 21.12.1992 DE 4243403
(71) Anmelder: Patent-Treuhand-Gesellschaft für elektrische Glühlampen mbH, D-81543 München (DE)
(72) Erfinder: Bernhard, Werner, D-86163 Augsburg (DE); Roll, Ulrich, Dr., D-86165 Augsburg (DE); Roth, Robert, Essex, Massachusetts 01929 (US); Schmitt, Harald, D-80686 München (DE); Reiser, Ludwig, D-86368 Gersthofen (DE)

(57) **Zusammenfassung**

Eine freischwingende Stromversorgungsschaltung umfaßt eine Steuerwicklung (RK1), eine erste Diode (D1), die mit der Anode in Serie mit der Steuerwicklung (RK1) geschaltet ist, eine zweite Diode (D2), die mit der Anode in Serie mit der Steuerwicklung (RK1) geschaltet ist, einen zwischen den Kathoden der ersten und zweiten Dioden (D1, D2) geschalteten Widerstand (R), einen Transistor (T1), dessen Kollektor zwischen der Kathode der ersten Diode (D1) und dem Widerstand (R) und dessen Basis zwischen der Kathode der zweiten Diode (D2) und dem Widerstand (R) angeschlossen ist und einen mit der zweiten Diode (D2) parallelgeschalteten Kondensator (C).

## Beschreibung

Die Erfindung betrifft eine freischwingende Stromversorgungsschaltung bzw. eine Schaltung für ein elektronisches Vorschaltgerät (EVG), die beispielsweise zum Zünden und Betreiben von Niederdruckentladungslampen verwendet wird.

Ein Beispiel für eine freischwingende Stromversorgungsschaltung zeigt das Bild B 3.12 auf Seite 148 des Buches "Elektronik-Schaltungen" von W. Hirschmann, Siemens AG, 1982. Für eine solche Schaltung werden häufig bipolare Schalttransistoren verwendet, wobei es günstig ist, ein "Entsättigungsnetzwerk" zu benutzen, um die Speicherzeit der Transistoren zu verringern und gleichzeitig damit Frequenzstreuungen der freischwingenden Schaltung zu minimieren.

Bei jeder freischwingenden Stromversorgungs-oder EVG-Schaltung muß die Oszillation nach dem Anlegen der Versorgungsspannung erstmalig starten. Es ist bekannt, daß zum Start der freischwingenden Oszillation eine Monoflop-Schaltung, beispielsweise mit Hilfe eines Diacs, benutzt wird. Es ist aber auch möglich, daß mindestens einer der verwendeten Schalttransistoren durch einen kleinen Basisstrom als Verstärker verwendet wird. Da freischwingende Inverter über Mitkopplungswicklungen die Basen der Schalttransistoren ansteuern, kann bei jeder Erfüllung des Mitkoppelkriteriums eine kleine, immer vorhandene Rausch-Spannung so weiterverstärkt werden, daß die Schaltung anschwingt. Dies wird auch mit Rauschanlauf bezeichnet.

Bei bisherigen Schaltungen wird entweder die stark streuende Speicherzeit der bipolaren Schalttransistoren akzeptiert bzw. über Sortierverfahren in Gruppen eingeteilt, oder sie wird mittels einer Entsättigungsschaltung ganz oder teilweise beseitigt.

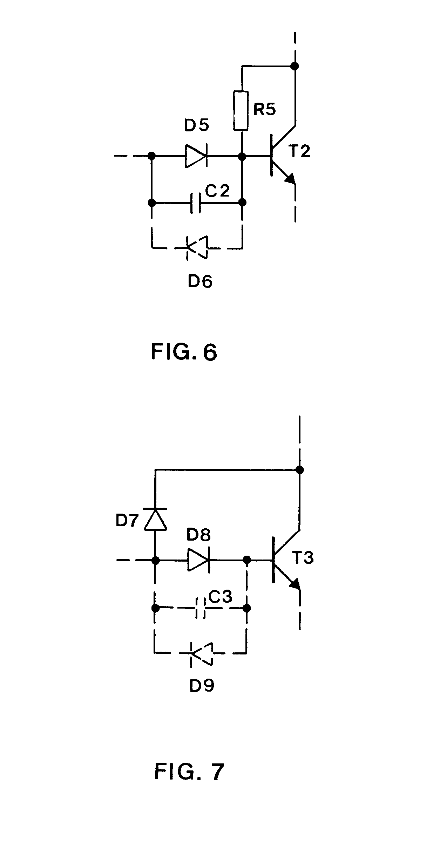

In den Figuren 6 und 7 sind Schaltungsbeispiele für die Unterstützung des Rauschanlaufs und für eine Entsättigung dargestellt.

Die in Figur 6 dargestellte Schaltung zur Bewirkung des Rauschanlaufs enthält einen Schalttransistor T2, dessen Kollektor über einen Widerstand R5 mit der Basis verbunden ist. An der Basis des Transistors T2 ist eine Diode D5 angeschlossen, wobei die Kathode der Diode D5 mit der Basis des Transistors T2 verbunden ist. Zu dieser Diode D5 kann parallel ein Kondensator C2 oder eine weitere Diode D6 antiparallel zur Diode 5 oder beides angeordnet sein.

Diese Schaltung gemäß Figur 6 arbeitet wie folgt: der hochohmige Widerstand R5 gibt einen kleinen Strom, beispielsweise ca. 1 mA, auf die Basis des Transistors T2. Die Diode D5 verhindert dabei ein Abfließen des Stromes über die folgende Steuerbeschaltung, die beispielsweise aus einem Widerstand und einer Wicklung oder Wicklungen auf einem Stromwandler bestehen kann. Der Transistor T2 wird in den Klasse A-Bereich gesteuert. Der Kondensator C2 setzt die Schwelle der Diode D5 herab und erleichtert so das Mitkoppelkriterium und unterstützt zudem, eventuell mit der weiteren Diode D6, das Ausräumen des Transistors.

Die in Figur 7 dargestellte Entsättigungsschaltung besteht aus einem Transistor T3, dessen Kollektor und dessen Basis jeweils mit der Kathode einer ersten Diode D7 bzw. einer zweiten Diode D8 verbunden sind, wobei die jeweiligen Anoden zusammengeschaltet sind. Analog zu der in Figur 6 dargestellten Schaltung kann eine weitere Diode D9, antiparallel zur Diode D8, oder ein Kondensator C3 oder beides angeordnet sein.

Bei der in Figur 7 dargestellten Entsättigungsschaltung kann der Transistor T3 nicht beliebig weit sättigen, da sonst sein Ansteuerstrom über die Diode D7 auf den Kollektor abgeleitet wird und nicht mehr über die Diode D8 zur Basis gelangt. Die Basisdiode D8 kann auch aus mehreren in Serie geschalteten Dioden oder auch aus einer Zenerdiode bestehen, wobei bei der Verwendung einer Zenerdiode die Anode und die Kathode miteinander vertauscht sein müssen. Die wahlweise vorgesehenen Bauteile, nämlich der Kondensator C3 und/oder die Diode D9 können das Ausräumen verbessern.

Der Erfindung liegt nun die Aufgabe zugrunde, eine Schaltung anzugeben, die sowohl den Rauschanlauf der freischwingenden Stromversorgungsschaltung ermöglicht als auch eine Entsättigung der Transistoren vernimmt. Die Schaltung sollte dabei einen kompakten und kostengünstigen Aufbau haben.

Diese Aufgabe wird erfindungsgemäß durch die Merkmale des Patentanspruchs 1 gelöst. Vorteilhafte Weiterbildungen sind in den Unteransprüchen angegeben.

Die erfindungsgemäße freischwingende Stromversorgungsschaltung umfaßt eine Steuerwicklung, eine erste Diode, die mit der Anode in Serie an die Steuerwicklung geschaltet ist, eine zweite Diode, die ebenfalls mit der Anode in Serie an die Steuerwicklung geschaltet ist, einen zwischen den Kathoden der ersten und der zweiten Diode geschalteten Widerstand, einen Transistor, dessen Kollektor zwischen der Kathode der ersten Diode und dem Widerstand und dessen Basis zwischen der Kathode der zweiten Diode und dem Widerstand angeschlossen sind und einen der zweiten Diode parallel geschalteten Kondensator.

Die erste Diode bewirkt die Ableitung des nicht benötigten und nur unnötig sättigenden Steuerstroms über den Kollektor des Transistors. Die zweite Diode kompensiert den Spannungsabfall über die erste Diode und verhindert, daß der über den Widerstand zum Rauschanlauf benötigte kleine Steuerstrom über die Steuerwicklung verlorengeht. Der Kondensator setzt die Spannungsschwelle der ersten Diode im Anlauf herab und hilft beim Abschalten des Transistors, die darin vorhandene Basisladung auszuräumen.

Soll die Kapazität des Kondensators deutlich kleiner als 100 nF sein, beispielsweise 10 nF, so ist es für ein gutes Abschaltverhalten des Transistors vorteilhaft, eine zusätzliche dritte Diode parallel zum Kondensator, aber antiparallel zur zweiten Diode zu schalten.

Wird, wie in EVG's üblich, parallel zum Transistor eine Freilaufdiodenfunktion benötigt, so wird die Kathode der entsprechenden Freilaufdiode mit dem Kollektor des Transistors und die Anode mit dem Emitter des Transistors verbunden.

Besonders vorteilhaft ist es, die Funktion der hochsperrenden und teuren Freilaufdiode durch eine zusätzlich niedersperrende Diode, deren Kathode mit den Anoden der ersten und der zweiten Diode und dem Kondensator und deren Anode mit der Steuerwicklung und dem Emitter des Transistors verbunden ist, über die von vornherein vorhandene erste Diode nachzubilden. In Reihe zur Steuerwicklung kann zur Strombegrenzung eine Basis-Impedanz -im einfachsten Fall ein ohmscher Widerstand- geschaltet sein, ebenso kann zur Bedämpfung unerwünschter Signalanteile parallel zur Steuerwicklung eine Bedämpfungs-Impedanz -auch hier im einfachsten Fall ein ohmscher Widerstandverwendet werden.

Um eine Gegenkopplung zu erreichen und somit Steuerungen einzuengen, kann zusätzlich in Reihe zum Emitter des Transistors eine Emitter-Impedanz geschaltet sein, oder auch eine Diode als nichtlinearer Gegenkopplungswiderstand.

Ein besonders bevorzugtes Dimensionierungsbeispiel für die verwendeten Bauteile ist im Unteranspruch 6 angegeben.

Soll die erfindungsgemäße Schaltung oder Teile davon in integrierten Bausteinen verwirklicht werden, ist es von Vorteil, bei vorhandener Basis-Impedanz den Kondensator parallel zur aus Basis-Impedanz und zweiter Diode bestehenden Reihenschaltung anzuschließen. Dadurch wird die Anzahl der Anschlüsse des integrierten Bausteins reduziert.

Mit Hilfe der erfindungsgemäßen Schaltung ist es möglich, den Raumbedarf der EVG's zu minimieren, da die verwendeten Bauteile mehrfach bzw. gemeinsam sowohl für den Rauschanlauf als auch für die Entsättigung genutzt werden können und sich somit ein wesentlich geringerer Herstellungsaufwand ergibt.

Weitere Vorteile und Merkmale der Erfindung ergeben sich aus der folgenden Beschreibung mehrerer Ausführungsformen sowie aus den Zeichnungen, auf die Bezug genommen wird. Es zeigen:

Figur 1 ein Teilschaltbild der freischwingenden Stromversorgungsschaltung gemäß einer ersten Ausführungsform;
Figur 2 ein Teilschaltbild einer freischwingenden Stromversorgungsschaltung gemäß einer zweiten Ausführungsform;
Figur 3 ein Teilschaltbild einer freischwingenden Stromversorgungsschaltung gemäß einer dritten Ausführungsform;
Figur 3a eine Variante des Teilschaltbildes von Figur 3 mit Bedämpfungs-, Basis- und Emitter-Impedanzen
Figur 4 ein Teilschaltbild einer freischwingenden Stromversorgungsschaltung gemäß einer vierten Ausführungsform;
Figur 4a eine Variante des Teilschaltbildes von Figur 4 mit Bedämpfungs-, Basis- und Emitter-Impedanzen
Figur 5 ein Teilschaltbild einer freischwingenden Stromversrogungsschaltung gemäß einer fünften Ausführungsform; Figuren 5a, 5b und 5c Varianten des Teilschaltbildes von Figur 4a
Figur 6 ein bekanntes Schaltbild einer Schaltungsanordnung zur Bewirkung des Rauschanlaufs;
Figur 7 ein bekanntes Schaltbild einer Schaltungsanordnung zur Durchführung der Entsättigung.

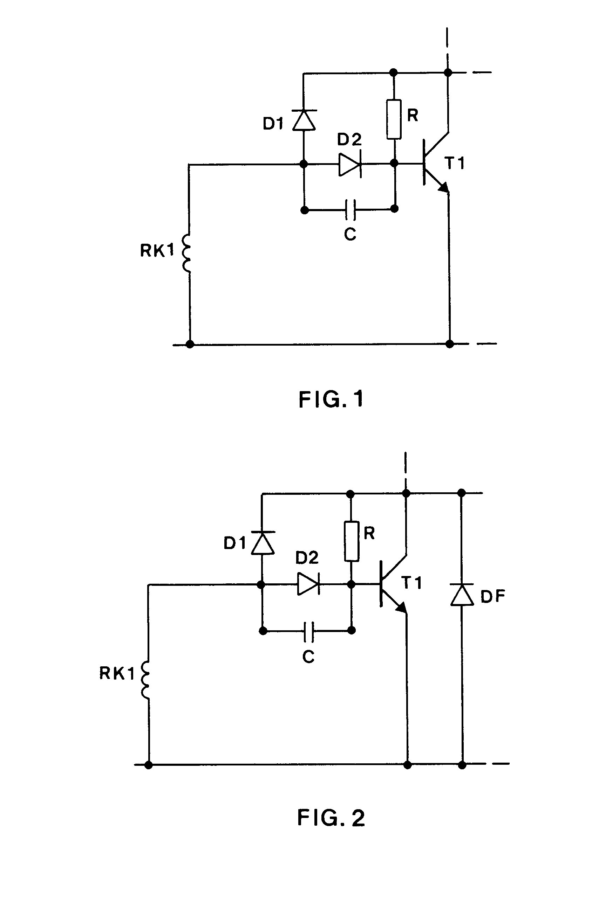

In Figur 1 ist ein Teilschaltbild einer freischwingenden Stromversorgungsschaltung gemäß einer ersten Ausführungsform dargestellt. Diese Schaltungsanordnung besteht aus einer Steuerwicklung RK1, mit der die Anode einer ersten Diode D1 in Serie geschaltet ist, und deren Kathode mit dem Kollektor eines Transistors T1 verbunden ist. Eine zweite Diode D2, die mit der Anode ebenfalls in Serie mit der Steuerwicklung RK1 geschaltet ist, ist über ihre Kathode mit der Basis eines Transistors T1 verbunden.

Die beiden Kathoden der ersten Diode D1 und der zweiten Diode D2 sind über einen Widerstand R miteinander verbunden. Mit der zweiten Diode D2 ist ein Kondensator C parallelgeschaltet. Der Emitter des Transistors T1 ist mit der Steuerwicklung RK1 verbunden.

Die in Figur 2 bis Figur 5c angegebenen weiteren Ausführungsformen der freischwingenden Stromversorgungsschaltung unterscheiden sich von der Ausführungsform gemäß Figur 1 lediglich durch zusätzliche Bauteile, so daß die mit der Figur 1 gleichen Bauteile auch die gleichen Bezugszahlen aufweisen.

Die in Figur 2 dargestellte Ausführungsform unterscheidet sich von derjenigen gemäß Figur 1 darin, daß die bei EVG's gewünschte Freilaufdiodenfunktion durch eine Freilaufdiode DF verwirklicht wird, die mit ihrrer Kathode an den Kollektor und mit ihrer Anode an den Emitter des Transistors T1 angeschlossen ist.

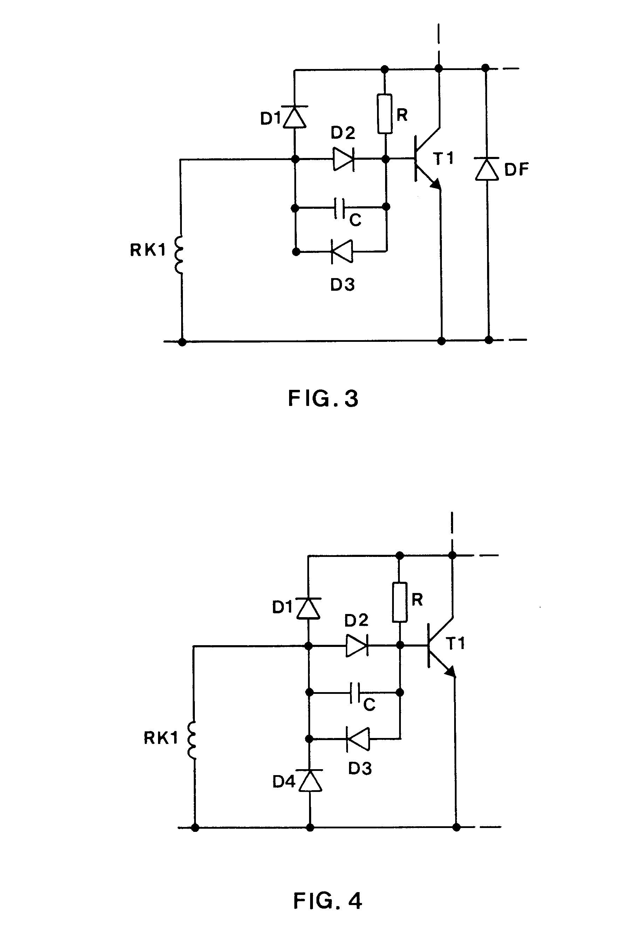

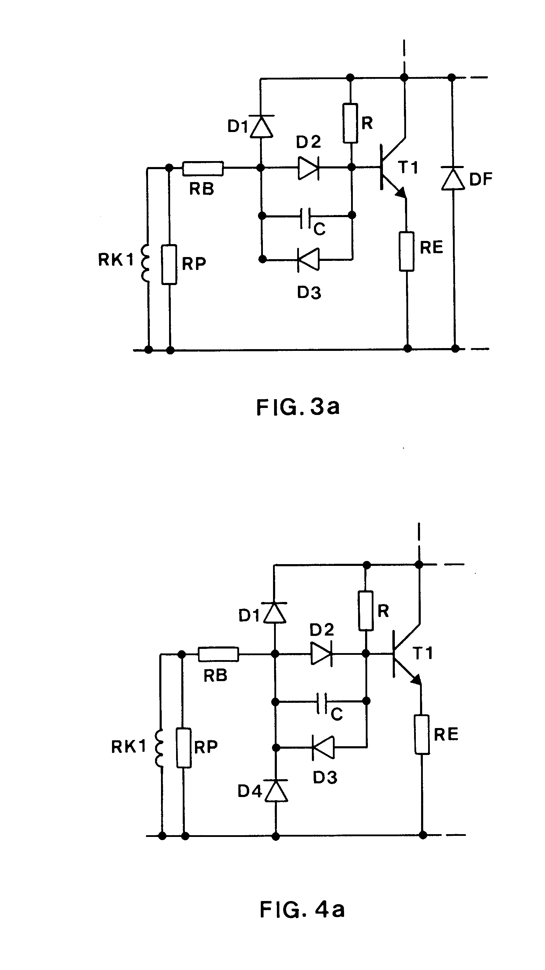

Die in Figur 3 dargestellte Ausführungsform unterscheidet sich von der in Figur 2 dargestellten durch eine parallel zum Kondensator C geschaltete dritte Diode D3, die antiparallel zur zweiten Diode D2 angeschlossen ist. Diese dritte Diode D3 ist dann notwendig, wenn die Kapazität des Kondensators C deutlich kleiner als 100 nF, beispielsweise 10 nF, gewählt werden soll, um ein gutes Abschaltverhalten des Transistors T1 sicherzustellen.

In Figur 4 ist eine Ausführungsform dargestellt, die die für EVG's übliche und gewünschte Freilaufdiodenfunktion ohne hochsperrende und teure Freilaufdiode ermöglicht. Die Funktion der Freilaufdiode wird über eine zusätzliche, niedersperrende vierte Diode D4 und über die vorhandene erste Diode D1 nachgebildet. Die vierte Diode D4 ist dabei so geschaltet, daß deren Kathode mit den Anoden der ersten und zweiten Dioden D1 und D2 und dem Kondensator C und deren Anode mit der Steuerwicklung RK1 und dem Emitter des Transistors T1 verbunden ist.

In Figur 3a und Figur 4a sind zusätzlich Impedanzen RP,RB und RE eingefügt, die einzeln oder auch in Kombination die Schaltungseigenschaften verbessern oder anpassen können. Die Bedämpfungs-Impedanz RP -im einfachsten Fall ein ohmscher Widerstand- kann parallel zur Steuerwicklung unerwünschte Signalanteile bedämpfen. Die Basis-Impedanz RB -im einfachsten Fall ebenso ein ohmscher Widerstand- kann den Steuerstrom begrenzen oder anpassen.

Die Emitter-Impedanz RE -als ohmscher Widerstand oder auch als nichtlinearer Widerstand- bewirkt eine Gegenkopplung und verringert somit Streuungen.

Ein besonders bevorzugtes Ausführungsbeispiel entsprechend Figur 4a weist folgende Spezifizierung auf:
RB = 22 Q
R = 470 kQ
RE = 1 Q
RP = 470 Q
T1 = BUV46 oder BUT93
C = 100 nF
D1 = BA157
D2 = 1 N4148
D3 = 1 N4148
D4 = 1 N4148
DF = BA157

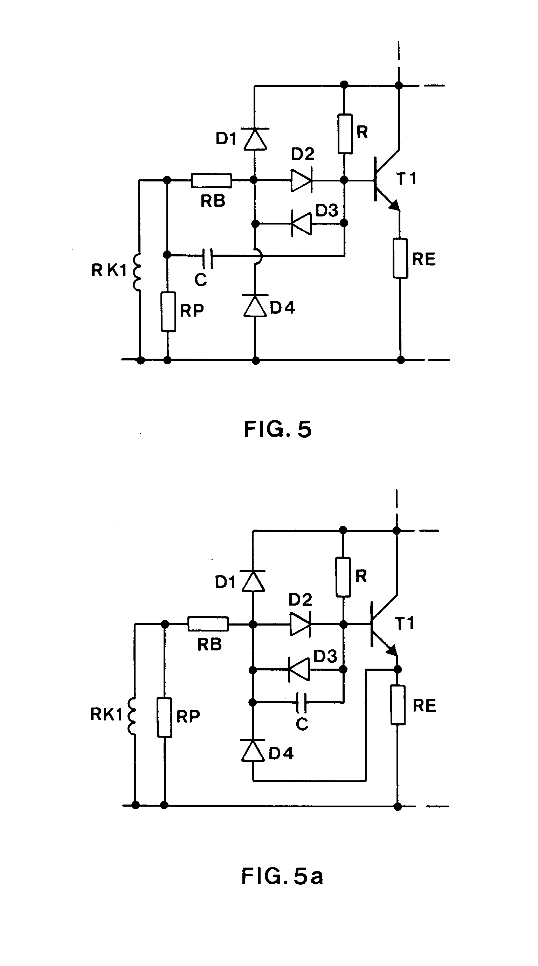

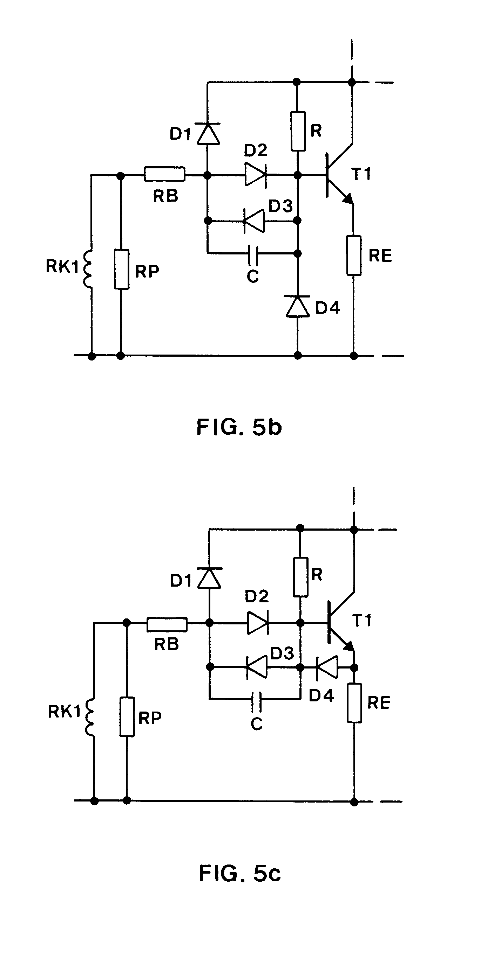

Die in Figur 5 dargestellte Ausführungsform ist zwar im Vergleich zur Ausführungsform gemäß Figur 4a gezeigt, läßt sich aber auch in den übrigen Ausführungsformen verwirklichen.

Im Unterschied zu Figur 4a ist der Kondensator C hier zur aus dem Widerstand RB und der zweiten Diode D2 bestehenden Reihenschaltung parallelgeschaltet. Dies ist dann von Vorteil, wenn die Schaltung oder Teile davon in integrierten Bausteinen verwirklicht werden, da dadurch die Anzahl der Anschlüsse reduziert ist. Dieses Ausführungsbeispiel weist allerdings eine andere Spezifizierung seiner Bauteile auf.

Figuren 5a, 5b uns 5c zeigen mögliche Abwandlungen in der Beschaltung der Diode D4, die ebenfalls eine Freilauffunktion mittelbar über die Diode D1 gewährleisten.

## Patentansprüche

1. Freischwingende Stromversorgungsschaltung mit
- einer Steuerwicklung (RK1),
- einer ersten Diode (D1 die mit der Anode in Serie mit der Steuerwicklung (RK1) geschaltet ist,
- einer zweiten Diode (D2), die mit der Anode in Serie mit der Steuerwicklung (RK1) geschaltet ist,
- einem zwischen den Kathoden der ersten und zweiten Dioden (D1, D2) geschalteten Widerstand (R),
- einem Transistor (T1), dessen Kollektor zwischen der Kathode der ersten Diode (D1) und dem Widerstand (R) und dessen Basis zwischen der Kathode der zweiten Diode (D2) und dem Widerstand (R) angeschlossen sind, und mit
- einem mit der zweiten Diode (D2) parallelgeschalteteten Kondensator (C).

2. Schaltung nach Anspruch 1, gekennzeichnet durch eine mit dem Kondensator (C) parallelgeschaltete dritte Diode (D3), wobei die dritte Diode (D3) antiparallel zur zweiten Diode (D2) geschaltet ist.

3. Schaltung nach den Ansprüchen 1 oder 2, gekennzeichnet durch eine Freilaufdiode (DF), deren Kathode mit dem Kollektor des Transistors (T1) und deren Anode mit dem Emitter des Transistors (T1) verbunden ist.

4. Schaltung nach den Ansprüchen 1 oder 2, gekennzeichnet durch eine vierte Diode (D4), deren Kathode mit den Anoden der ersten und zweiten Diode (D1, D2) und dem Kondensator (C) und deren Anode mit der Steuerwicklung (RK1) und dem Emitter des Transistors (T1) verbunden sind.

5. Schaltung nach einem der Ansprüche 1 bis 4, dadurch gekennzeichnet, daß
- parallel zur Steuerwicrwicklung (RK1) eine Bedämpfungs-Impedanz (RP) geschaltet ist, und/oder
- in Serie zur Steuerwicklung (RK1) eine Basis-Impedanz (RB) zwischen Steuerwicklung (RK1) und die Anoden der ersten und zweiten Dioden (D1, D2) geschaltet ist, und/oder
- in Serie zum Emitter des Transistors (T1) eine Emitter-Impedanz (RE) geschaltet ist.

6. Schaltung nach einem der Ansprüche 1 bis 5, dadurch gekennzeichnet, daß die einzelnen Bauelemente folgende Spezifizierung umfassen:
RB = 22 Q
R = 470 kQ
RE = 1 Q
RP = 470 Q
T1 = BUV46 oder BUT93
C = 100 nF
D1 = BA157
D2 = 1 N4148
D3 = 1 N4148
D4 = 1 N4148
DF = BA157

7. Schaltung nach einem der Ansprüche 1 bis 5, dadurch gekennzeichnet, daß der Kondensator (C) alternativ zu der in Anspruch 1 beanspruchten Position zu der aus der Basis-Impedanz (RB) und der zweiten Diode (D2) bestehenden Reihenschaltung parallelgeschaltet ist.

8. Schaltung nach einem der Ansprüche 1 bis 7, dadurch gekennzeichnet, daß die vierte Diode (D4) alternativ zu der in Anspruch 4 beanspruchte Position entweder
- mit ihrer Kathode zwischen den Anoden der ersten und zweiten Diode (D1, D2) und mit ihrer Anode zwischen dem Emitter des Transistors (T1) und der Emitter-Impedanz (RE) oder
- mit ihrer Kathode an der Basis des Transistors (T1) und mit ihrer Anode zwischen der Steuerwicklung (RK1) und der Emitter-Impedanz (RE) oder
- mit ihrer Kathode an der Basis des Transistors (T1) und mit ihrer Anode zwischen dem Emitter des Transsistors (T1) und der Emitter-Impedanz (RE)
angeschlossen ist.
